# EUROPEAN PATENT APPLICATION

(11) **EP 3 734 619 A1**
(43) Date of publication of application: **04.11.2020**
(21) Application number: 18894443.3
(22) Date of filing: 26.12.2018
(51) Int. Cl.: H01B 13/00, H01B 7/00

(54) **DEVICE FOR ELECTRICALLY CONNECTING ELECTRODE, FLEXIBLE ELECTRODE HAVING ELECTRICAL CONNECTION PART FORMED BY USING SAME, AND METHOD FOR ELECTRICALLY CONNECTING ELECTRODE BY USING SAME**

(30) Priority: 27.12.2017 KR 20170181582
(71) Applicant: Kolon Industries, Inc., Seoul 07793 (KR)
(72) Inventor: KAL, Jin Ha, Seoul 07793 (KR); LEE, Won Hee, Seoul 07793 (KR); KU, Ja Ram, Seoul 07793 (KR); KIM, Kwang-Su, Seoul 07793 (KR)
(74) Representative: Ter Meer Steinmeister & Partner
(86) International application number: PCT/KR2018/016670
(87) International publication number: WO 2019/132514

(57) **Abstract**

The present invention provides a device for electrically connecting an electrode which includes an upper electrode connection member 100 including an upper sealing cap 10 and one or more conductive fixing nails 22 which are fixed to a lower surface of the sealing cap and connected to an electrical wiring 24 withdrawn outward; and a lower electrode connection member 100' including a lower sealing cap 10' and a conductive fixing nail fixing means 22' which is formed as a part of the sealing cap on the upper surface of the sealing cap or separately provided thereon, wherein the lower surface of the upper sealing cap 10 includes a sealing groove 12 which includes fixing portions of the conductive fixing nails 22 therein and includes one or more sealing agent injection hole 14 communicating with the upper surface of the upper sealing cap, and the upper surface of the lower sealing cap 10' includes a sealing groove 12' which includes the conductive fixing nail fixing means 22' therein and includes one or more sealing agent injection hole 14' communicating with the lower surface of the lower sealing cap 10', a flexible electrode having an electrical connection part formed by employing the same, and a method for electrically connecting an electrode by using the same.

## Description

### [Technical Field]

This application claims priority to and the benefit of Korean Patent Application No. 10-2017-0181582 filed on December 27, 2017, the entire contents of which are incorporated herein by reference.

The present invention relates to a device for electrically connecting an electrode, a flexible electrode having an electrical connection part formed by using the same, and a method for electrically connecting an electrode using the same.

### [Background Art]

In recent years, the demand for mobile electronic devices such as portable telephones and notebooks has been continuously increased. In particular, interest in flexible mobile electronic devices to which rollable displays, flexible e-papers, flexible liquid crystal displays (flexible-LCDs), flexible organic light-emitting diodes (flexible-OLEDs), and the like are applied has been increased. Accordingly, it is required that an electrode included in the flexible mobile electronic device also has a flexible characteristic.

The electrode having the flexible characteristic needs to be sealed by positioning a flexible protective layer on the top and bottom of the electrode. Therefore, in order to connect such a flexible electrode with another device, a part of the protective layer is removed and connected, or connected by a via contact method.

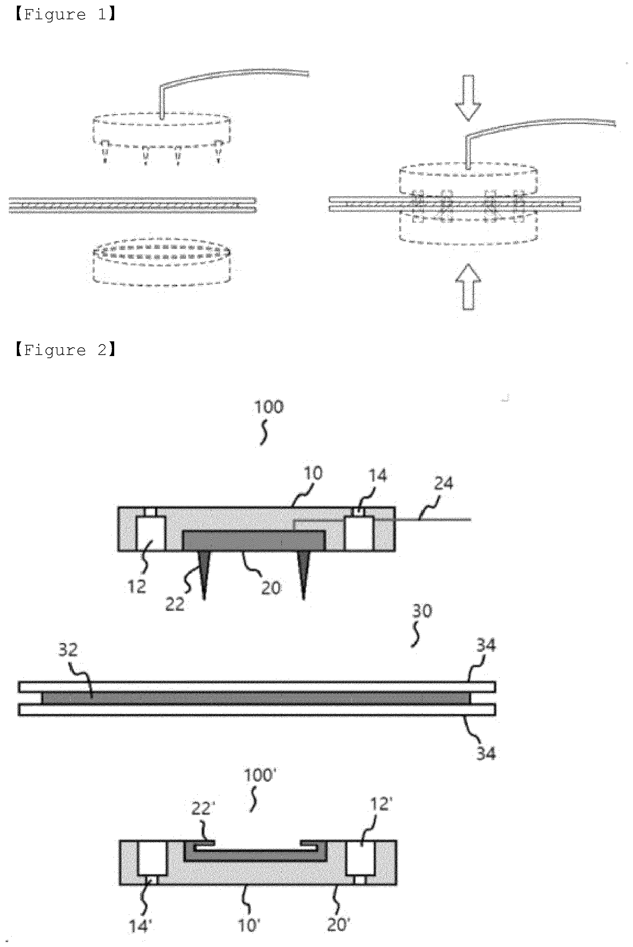

The via contact method is performed in the same manner as illustrated in FIG. 1, that is, in the method that a flexible electrode 30 is positioned between a conductive plate 20 which has one or more conductive fixing nails 22 provided on a lower surface thereof and is connected to an electrical wiring 24 withdrawn outward and a fixing plate 20' which has a conductive fixing nail fixing means 22' provided on an upper surface thereof, and the conductive fixing nails 22 are fixed by the conductive fixing nail fixing means 22' by pressing the conductive plate 20 and the fixing plate 20' upward and downward.

However, in both the via contact method and the connection method by partially removing the protective layer, an encapsulating agent such as a sealant needs to be applied to an exposed area to seal the electrode to be inevitably exposed after connecting an electrode.

However, the additional sealing as described above is not only cumbersome, but also may cause deformation of an electrode material, and has a disadvantage in spoiling the appearance of the electrode.

Therefore, there is a need to promptly solve the above problems in a manufacturing field of flexible devices.

### [Prior Art Document]

### [Patent Document]

Korean Patent Publication No. 10-2013-0123236

### [Disclosure]

### [Technical Problem]

The present invention is derived to solve the problems of the prior art as described above, and an object of the present invention is to provide a device for electrically connecting an electrode capable of very simply connecting a sealing electrode with an external device, very easily performing sealing after connecting, and providing a very excellent appearance of a connection part after connecting, a flexible electrode having an electrical connection part formed by using the same, and a method for electrically connecting an electrode using the same.

### [Technical Solution]

In order to achieve the object, the present invention provides a device for electrically connecting an electrode comprising:
an upper electrode connection member 100 including an upper sealing cap 10 and one or more conductive fixing nails 22 which are fixed to a lower surface of the sealing cap and connected to an electrical wiring 24 withdrawn outward; and
a lower electrode connection member 100' including a lower sealing cap 10' and a conductive fixing nail fixing means 22' which is formed as a part of the sealing cap on the upper surface of the sealing cap or separately provided thereon,
wherein the lower surface of the upper sealing cap 10 includes a sealing groove 12 which includes fixing portions of the conductive fixing nails 22 therein and includes one or more sealing agent injection hole 14 communicating with the upper surface of the upper sealing cap, and
the upper surface of the lower sealing cap 10' includes a sealing groove 12' which includes the conductive fixing nail fixing means 22' therein and includes one or more sealing agent injection hole 14' communicating with the lower surface of the lower sealing cap 10'.

Further, the present invention provides a flexible electrode having an electrical connection part formed by using the device for electrically connecting the electrode of the present invention.

Further, the present invention provides a method for electrically connecting an electrode using the device for electrically connecting the electrode of the present invention, the method comprising:
positioning an electrode 30 between an upper electrode connection member 100 and a lower electrode connection member 100';
fixing a conductive fixing nail 22 fixed to a lower surface of an upper sealing cap 10 to a conductive fixing nail fixing means 22' provided on an upper surface of the upper sealing cap 10 through the electrode 30 by pressing the upper electrode connection member 100 and the lower electrode connection member 100';
performing filling a sealing agent 40 in a sealing groove 12 by injecting the sealing agent 40 into a sealing agent injection hole 14 provided in the upper sealing cap 10 and filling a sealing agent 40 in a sealing groove 12' by injecting the sealing agent 40 into a sealing agent injection hole 14' provided in the lower sealing cap 10' in random order; and
curing the sealing agent 40 injected in the sealing grooves 12 and 12'.

### [Advantageous Effects]

According to the device for electrically connecting the electrode of the present invention, it is possible to very simply connect a sealing electrode with an external device, very easily perform the sealing after connecting, and provide a very excellent appearance of a connection part after connecting. Therefore, there is provided an effect capable of very efficiently performing an electrical connection of the sealing electrode.

According to the flexible electrode having the electrical connection part formed by using the device for electrically connecting the electrode of the present invention, it is possible to provide excellent electrical contact, excellent sealing, and excellent appearance.

Further, according to the method for electrically connecting the electrode of the present invention, it is possible to very simply connect an electrode with an external device, very easily perform the sealing after connecting, and provide a very excellent appearance of a connection part after connecting.

### [Description of Drawings]

FIG. 1 is a diagram illustrating a device for electrically connecting an electrode by a via contact method in the related art.
FIG. 2 is a cross-sectional view schematically illustrating a state before coupling a device for electrically connecting an electrode as an embodiment of the present invention.
FIGS. 3 and 4 are a cross-sectional view and a perspective view schematically illustrating a state while coupling a device for electrically connecting an electrode as an embodiment of the present invention.
FIGS. 5 and 6 are a cross-sectional view and a perspective view schematically illustrating an injection state of a sealing agent after coupling a device for electrically connecting an electrode as an embodiment of the present invention.
FIG. 7 is a plan view and a bottom view of a state in which the device for electrically connecting the electrode as an embodiment of the present invention is fixed to the electrode.

### [Best Mode]

Hereinafter, preferred embodiments of the present invention will be described in detail with reference to the accompanying drawings. Before describing the present invention, if it is determined that the detailed description of the related known functions and configurations may unnecessarily obscure the subject matter of the present invention, the description thereof will be omitted.

The following description and drawings illustrate certain embodiments so that those skilled in the art can easily implement a device and a method to be described below. Other embodiments may include structurally and logically different modifications. Individual components and functions can generally be selected unless explicitly required, and the order of the processes can be varied. Portions and features of some embodiments may be included in or substituted with other embodiments.

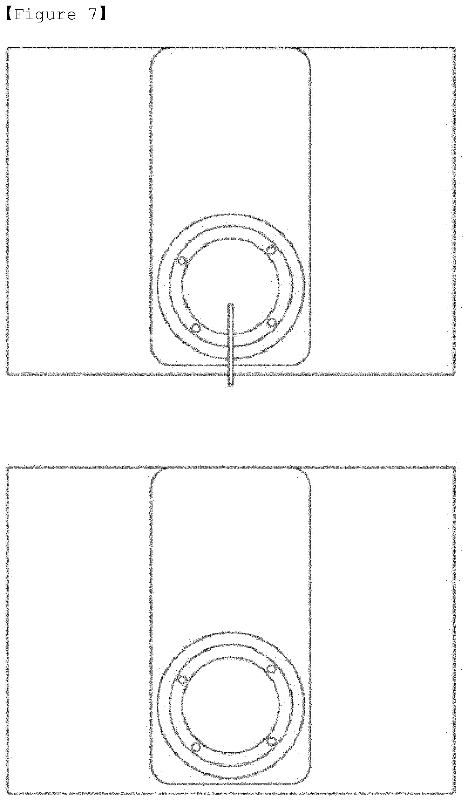

The present invention provides a device for electrically connecting an electrode as illustrated in FIGS. 2 to 7. That is, the electrically connecting device of the present invention includes an upper electrode connection member 100 including an upper sealing cap 10 and one or more conductive fixing nails 22 which are fixed to a lower surface of the sealing cap and connected to an electrical wiring 24 withdrawn outward; and
a lower electrode connection member 100' including a lower sealing cap 10' and a conductive fixing nail fixing means 22' which is formed as a part of the sealing cap on the upper surface of the sealing cap or separately provided thereon,
wherein the lower surface of the upper sealing cap 10 includes a sealing groove 12 which includes fixing portions of the conductive fixing nails 22 therein and includes one or more sealing agent injection hole 14 communicating with the upper surface of the upper sealing cap, and
the upper surface of the lower sealing cap 10' includes a sealing groove 12' which includes the conductive fixing nail fixing means 22' therein and includes one or more sealing agent injection hole 14' communicating with the lower surface of the lower sealing cap 10'.

As the materials of the upper sealing cap 10 and the lower sealing cap 10', materials capable of sealing air and moisture may be used without limitation, and for example, a plastic material and the like as a polymer material may also be used.

The shapes of the upper sealing cap 10 and the lower sealing cap 10' are not particularly limited, and for example, as illustrated in FIGS. 2 to 7, a cylindrical shape may be used.

The conductive fixing nail 22 may be generally formed of a conductive metal although the material thereof is not particularly limited so long as the material is a conductive material.

The conductive fixing nail fixing means 22' needs not to have conductivity and thus, an insulating material as well as the conductive material may also be used. For example, when the conductive fixing nail fixing means 22' is formed as a part of the lower sealing cap 10', the conductive fixing nail fixing means 22' may be formed of the same material as the lower sealing cap 10'.

The conductive fixing nail 22 may be in the form of a pin or a screw. FIGS. 2 to 7 illustrate the pin-shaped conductive fixing nails 22.

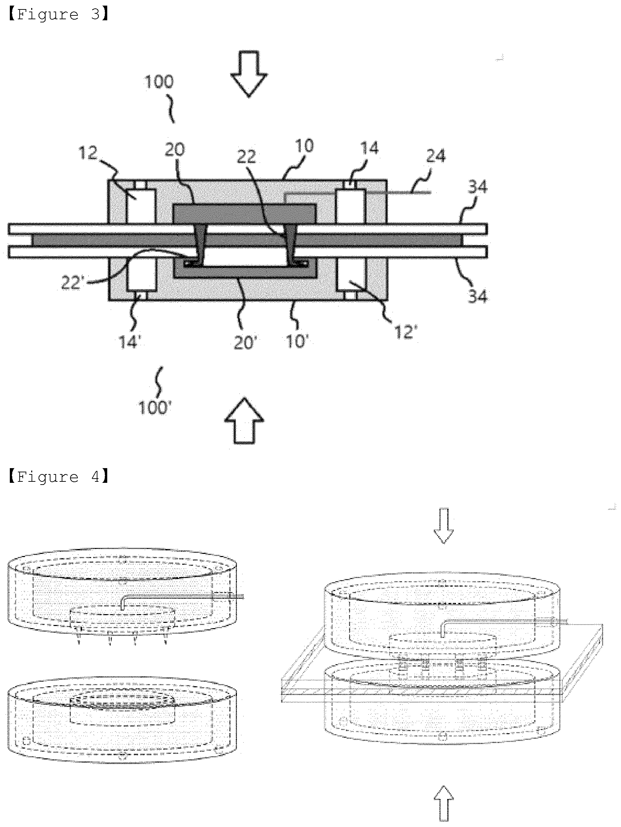

When the conductive fixing nail 22 is in the form of a pin, as illustrated in FIGS. 3 to 6, a tip of the pin-shaped fixing nail 22 may be bent by pressing.

The conductive fixing nail fixing means 22' may have a structure for fixing the fixing nail 22, which is bent by pressing, a structure for forming a locking jaw for the fixing nail 22, or a structure for fixing the fixing nail by forming friction with the fixing nail 22, as illustrated in FIGS. 2 to 6.

The sealing groove 12 of the lower surface of the upper sealing cap 10 and the sealing groove 12' of the upper surface of the lower sealing cap 10' may seal inner spaces of the sealing grooves 12 and 12' of the upper sealing cap 10 and the lower sealing cap 10' by forming gapless binding between the upper and lower surfaces of the electrode by injecting the sealing agent 40.

As the sealing agent 40, a sealing agent commonly used in the art may be used, and for example, a sealing agent such as a sealant may be used.

### [Modes of the Invention]

More specifically, as illustrated in FIGS. 2 to 7, the electrically connecting device of the present invention may have a structure in which the upper electrode connection member 100 further includes a conductive plate 20 which has the conductive fixing nail 22 fixed to the lower surface thereof and is connected to the electrical wiring 24 withdrawn outward.

Further, the lower electrode connection member 100' may further include a fixing plate 20' which has the conductive fixing nail fixing means 22' provided on the upper surface thereof.

In this case, the sealing groove 12 of the upper sealing cap 10 may be a ring-shaped groove 12 which is spaced apart from an outer circumference of the conductive plate 20.

The sealing groove 12' of the lower sealing cap 10' may be a ring-shaped groove 12' which is spaced apart from an outer circumference of the fixing plate 20'.

In the electrically connecting device of the present invention, as illustrated in FIGS. 1 to 6, the electrode 30 may be an electrode in which an upper surface and a lower surface of an electrode material 32 are sealed with a protective member 34 and the electrode 30 may be a flexible electrode.

Further, the present invention provides a flexible electrode having an electrical connection part formed by using the device for electrically connecting the electrode.

The flexible electrode may be preferably used because the flexible electrode provides excellent electrical contact, excellent sealing, and excellent appearance.

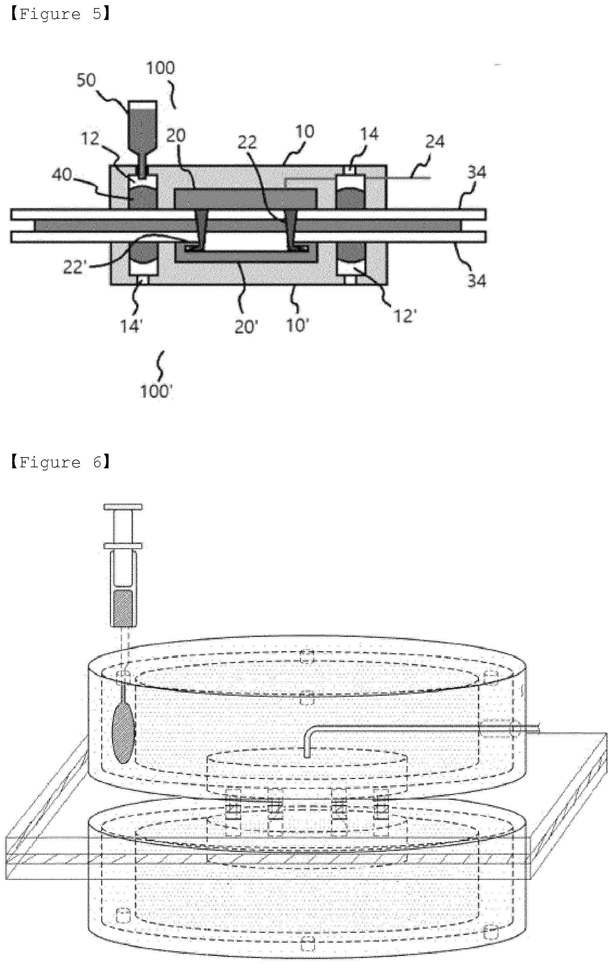

Further, the present invention relates to a method for electrically connecting an electrode using the device for electrically connecting the electrode of the present invention, the method comprising:
positioning an electrode 30 between an upper electrode connection member 100 and a lower electrode connection member 100', as illustrated in FIG. 2;
fixing a conductive fixing nail 22 fixed to a lower surface of an upper sealing cap 10 to a conductive fixing nail fixing means 22' provided on an upper surface of the upper sealing cap 10 through the electrode 30 by pressing the upper electrode connection member 100 and the lower electrode connection member 100', as illustrated in FIGS. 3 and 4;
performing filling a sealing agent 40 in a sealing groove 12 by injecting the sealing agent 40 into a sealing agent injection hole 14 provided in the upper sealing cap 10 and filling a sealing agent 40 in a sealing groove 12' by injecting the sealing agent 40 into a sealing agent injection hole 14' provided in the lower sealing cap 10' in random order, as illustrated in FIGS. 5 and 6; and
curing the sealing agent 40 injected in the sealing grooves 12 and 12'.

In the method for electrically connecting the electrode, all the contents described in the device for electrically connecting the electrode may be applied in the same manner.

Although the present invention has been described in connection with the preferred embodiments mentioned above, it is possible to make various modifications or variations without departing from the spirit and scope of the invention. Therefore, the appended claims will include such modifications or variations as long as being included within the spirit of the present invention.

**[Explanation of Numeral References and Symbols]**

| | |
|---|---|
| 10: Upper sealing cap | 12, 12': Sealing groove |
| 14, 14': Sealing agent injection hole | |
| 20: Conductive plate | |
| 20': Fixing plate | 22: Conductive fixing nail |
| 22': Conductive fixing nail fixing means | |
| 24: Electrical wiring | |
| 30: Electrode | 32: Electrode material |
| 34: Protective layer | 40: Sealing agent |
| 50: Sealing agent injection device | |

## Claims

1. A device for electrically connecting an electrode comprising:
an upper electrode connection member including an upper sealing cap and one or more conductive fixing nails which are fixed to a lower surface of the sealing cap and connected to an electrical wiring withdrawn outward; and
a lower electrode connection member including a lower sealing cap and a conductive fixing nail fixing means which is formed as a part of the sealing cap on the upper surface of the sealing cap or separately provided thereon,
wherein the lower surface of the upper sealing cap includes a sealing groove which includes fixing portions of the conductive fixing nails therein and includes one or more sealing agent injection hole communicating with the upper surface of the upper sealing cap, and
the upper surface of the lower sealing cap includes a sealing groove which includes the conductive fixing nail fixing means therein and includes one or more sealing agent injection hole communicating with the lower surface of the lower sealing cap.

2. The device for electrically connecting the electrode of claim 1, wherein the upper sealing cap and the lower sealing cap are formed of polymer materials.

3. The device for electrically connecting the electrode of claim 1, wherein the conductive fixing nail is formed of a conductive metal.

4. The device for electrically connecting the electrode of claim 1, wherein the conductive fixing nail is in the form of a pin or a screw.

5. The device for electrically connecting the electrode of claim 1, wherein when the conductive fixing nail is in the form of a pin, a tip of the pin-shaped fixing nail is bent by pressing.

6. The device for electrically connecting the electrode of claim 1, wherein the conductive fixing nail fixing means has a structure for fixing the fixing nail which is bent by pressing, a structure for forming a locking jaw for the fixing nail, or a structure for fixing the fixing nail by forming friction with the fixing nail.

7. The device for electrically connecting the electrode of claim 1, wherein the sealing groove of the lower surface of the upper sealing cap and the sealing groove of the upper surface of the lower sealing cap seal inner spaces of the sealing grooves of the upper sealing cap and the lower sealing cap by forming gapless binding between the upper and lower surfaces of the electrode by injecting the sealing agent.

8. The device for electrically connecting the electrode of claim 1, wherein the upper electrode connection member further includes a conductive plate which has the conductive fixing nail fixed to the lower surface thereof and is connected to the electrical wiring withdrawn outward.

9. The device for electrically connecting the electrode of claim 1, wherein the lower electrode connection member further includes a fixing plate which has the conductive fixing nail fixing means provided on the upper surface thereof.

10. The device for electrically connecting the electrode of claim 8, wherein the sealing groove is a ring-shaped groove which is spaced apart from an outer circumference of the conductive plate.

11. The device for electrically connecting the electrode of claim 9, wherein the sealing groove is a ring-shaped groove which is spaced apart from an outer circumference of the fixing plate.

12. The device for electrically connecting the electrode of claim 1, wherein the electrode is an electrode in which an upper surface and a lower surface of an electrode material are sealed with a protective member.

13. The device for electrically connecting the electrode of claim 12, wherein the electrode is a flexible electrode.

14. A flexible electrode having an electrical connection part formed by using the device for electrically connecting the electrode of claim 1.

15. A method for electrically connecting an electrode using the device for electrically connecting the electrode of claim 1, the method comprising:
positioning an electrode between an upper electrode connection member and a lower electrode connection member;
fixing a conductive fixing nail fixed to a lower surface of an upper sealing cap to a conductive fixing nail fixing means provided on an upper surface of an upper sealing cap through the electrode by pressing the upper electrode connection member and the lower electrode connection member;
performing filling a sealing agent in a sealing groove by injecting the sealing agent into a sealing agent injection hole provided in the upper sealing cap and filling a sealing agent in a sealing groove by injecting the sealing agent into a sealing agent injection hole provided in the lower sealing cap in random order; and
curing the sealing agent injected in the sealing grooves.
